# EUROPÄISCHE PATENTSCHRIFT

(11) **EP 1 157 408 B1**
(45) Veröffentlichungstag und Bekanntmachung des Hinweises auf die Patenterteilung: **08.10.2003**
(21) Anmeldenummer: 00905002.2
(22) Anmeldetag: 02.02.2000
(51) Int. Cl.: H01L 21/00

(54) **VORRICHTUNG UND VERFAHREN ZUM THERMISCHEN BEHANDELN VON SUBSTRATEN**
DEVICE AND METHOD FOR THERMALLY TREATING SUBSTRATES
DISPOSITIF ET PROCEDE DE TRAITEMENT THERMIQUE DE SUBSTRATS

(30) Priorität: 22.02.1999 DE 19907497
(43) Veröffentlichungstag der Anmeldung: 28.11.2001
(73) Patentinhaber: Steag HamaTech AG, 75447 Sternenfels (DE)
(72) Erfinder: DRESS, Peter, D-76646 Bruchsal (DE); DIETZE, Uwe, Austin, TX 78734 (US); SZEKERESCH, Jakob, D-75328 Schönberg (DE); WEIHING, Robert, D-75417 Mühlacker (DE)
(74) Vertreter: Wagner, Karl H., Dipl.-Ing.
(86) Internationale Anmeldenummer: EP0000816
(87) Internationale Veröffentlichungsnummer: WO00051170

(56) Entgegenhaltungen:
- EP-A- 0 418 541
- US-A- 5 635 409
- US-A- 5 740 016
- PATENT ABSTRACTS OF JAPAN vol. 007, no. 280 (E-216), 14. Dezember 1983 (1983-12-14) -& JP 58 159329 A (CANON KK), 21. September 1983 (1983-09-21)

## Beschreibung

Die Erfindung bezieht sich auf Vorrichtungen und Verfahren zum thermischen Behandeln von Substraten mit einer Heizplatte, die eine Vielzahl von separat ansteuerbaren Heizelementen aufweist, und einer auf die von der Heizplatte abgewandte Oberfläche des Substrats gerichtete, ortsauflösende Temperaturmeßvorrichtung.

Derartige Vorrichtungen werden beispielsweise im Bereich der Halbfeiterindustrie im Anschluß an Belackungsvorgänge von Substraten, insbesondere Photomasken, verwendet, um die Substrate zur Aushärtung und chemischen Vorbehandlung der Schichten thermisch zu behandeln. Bei der thermischen Behandlung ist es für die nachfolgende Verwendbarkeit der Substrate wichtig, daß die aufgebrachten Schichten möglichst gleichmäßig und homogen behandelt werden. Dabei tritt jedoch das Problem auf, daß aufgrund einer erhöhten thermischen Abstrahlung eine gleichmäßige thermische Behandlung in den Eckbereichen von rechteckigen Substraten bzw. den Randbereichen von runden Substraten eine gleichmäßige Behandlung nicht gewährleistet werden kann.

Aus der JP-A-04-239120 ist einer Vorrichtung zum thermischen Behandeln von Substraten mit einer Heizplatte, die durch eine einzelne, in Segmenten unterschiedlich ansteuerbare Heizspirale erhitzt wird bekannt. Die Vorrichtung weist ferner eine auf die von der Heizplatte abgewandte Oberfläche des Substrats gerichtete, ortsauflösende Temperatur-Meßvorrichtung gemäß dem Oberbegriff des Anspruchs 1 auf. Bei einer derartigen Vorrichtung ergibt sich jedoch das Problem, daß eine gleichmäßige thermische Behandlung der Substrate nicht gewährleistet ist. Insbesondere ergibt sich das Problem, daß die einzelnen Segmente der Heizspirale häufig übersteuert werden, da die durch sie verursachten Heizeffekte am Substrat erst mit einer Verzögerung durch die ortsauflösende Temperaturmeßvorrichtung abgefühlt werden. Daher kommt es zu einem ständigen Über- und Unterschießen der tatsächlich erforderlichen Heiztemperatur durch die unterschiedlichen Segmente der Heizspirale.

Die JP-A-01-050717 zeigt eine Vorrichtung zum thermischen Behandeln von Substraten mit einer unteren Heizplatte, seitlichen Heizplatten und Temperatursensoren zum Messen der Temperatur der Heizplatten. Die von den Temperatursensoren gemessenen Temperaturen werden an entsprechende Regeleinheiten weitergeleitet, um die Heizleistung der Heizplatten zu regein. Eine derartige Regeleinheit, die in der Technik vielfach bekannt ist, ermöglicht jedoch keine Anpassung der Heizvorrichtung an die Substrattemperatur und ist somit nur bedingt geeignet eine homogene thermische Behandlung vorzusehen.

Aus der US-A-5715361 ist eine Schnellheizanlage für Halbleiterwafer bekannt. Die Wafer werden über Heizlampen erhitzt und die Temperatur des Wafers wird durch eine Vielzahl von Pyrometern auf einer Oberfläche des Wafers ermittelt. In Abhängigkeit von den ermittelten Temperaturwerten auf der Wafer-Oberfläche werden die einzelnen Heizlampen angesteuert. Bei dieser Vorrichtung ergeben sich dieselben Probleme, wie sie auch bei der JP-A-04-239120 auftreten.

Die US-A-5,740,016 zeigt ferner einen temperaturgesteuerterten Substrathalter, auf dessen Rückseite eine Vielzahl von Thermoelektromodulen vorgesehen ist, die über eine Stromversorgung mit Strom versorgt werden. Eine Infrarotkamera ist auf die vom Substrathalter abgewandte Oberfläche eines Wafers gerichtet, um die Temperatur über die Waferoberfläche hinweg zu messen. Die gemessene Temperaturverteilung wird an eine Steuereinheit weitergegeben, die in Abhängigkeit von der Temperaturverteilung die Stromversorgung ansteuert, um eine unterschiedliche Ansteuerung der thermoelektrischen Module zu erreichen.

Die US-A-5,635,409 beschreibt eine Vorrichtung zum thermischen Behandein von Halbleiterwafern, bei der ein Wafer über eine Vielzahl von Lampen erwärmt wird. Ein Mehrzonensensor mißt die Temperatur des Wafers an verschiedenen Punkten und gibt die Ergebnisse der Temperaturmessung an eine Steuereinheit weiter. In Abhängigkeit von der Temperaturverteilung werden die einzelnen Lampen der Vielzahl von Lampen unterschiedlich angesteuert, um eine homogenere Temperaturverteilung auf der Waferoberfläche zu erhalten.

Der vorliegenden Erfindung liegt daher die Aufgabe zugrunde, eine verbesserte Homogenität während einer thermischen Behandlung von Substraten vorzusehen.

Erfindungsgemäß wird die gestellte Aufgabe bei einer Vorrichtung zum thermischen Behandeln von Substraten mit einer Heizplatte durch die folgenden Merkmale gelöst: eine Vielzahl von separat ansteuerbaren Heizelementen auf der vom Substrat abgewandten Seite der Heizplatte, wenigstens einen Temperatursensor zum Abfühlen der Temperatur der Heizelemente, wenigstens einen mit den Heizelementen und dem wenigstens einen Temperatursensor in Verbindung stehenden PID-Regler, eine mit der Temperatur-Meßvorrichtung in Verbindung stehende Rechnereinheit, die die Temperaturverteilung auf der Substratoberfläche ermittelt, eine mit der Rechnereinheit in Verbindung stehende Prozeßsteuereinheit, die in Abhängigkeit von der Temperaturverteilung Temperatur-Sollwerte für die einzelnen Heizelemente ermittelt und an den PID-Regler weiterleitet. Durch eine Vorrichtung mit den obigen Merkmalen wird eine aktive Anpassung von Regelparametern eines Regelkreises anhand externer Meßergebnisse ermöglicht, so daß die Substrate einer homogenen thermischen Behandlung unterzogen werden. Aus den gemessenen Temperaturwerten ergibt sich eine Temperaturverteilung auf der Substratoberfläche, aus der gegebenenfalls veränderte Temperatur-Sollwerte für die Heizelemente ermittelbar sind. Diese werden in den durch PID-Regler, Heizelemente und Temperatursensor gebildeten Regelkreis eingespeist. Dadurch ist es möglich, die einzelnen Heizelemente derart einzustellen, daß innerhalb des Substrats eine gleichförmige Temperaturverteilung erreicht wird. Insbesondere kann für die Heizelemente in den problematischen Rand- und Kantenbereichen eine höhere Temperatur vorgegeben werden.

Um ein thermisches Übersprechen zwischen den einzelnen Heizelementen zu unterbinden, sind die Heizelemente auf der vom Substrat abgewandten Seite der Heizplatte voneinander beabstandet. Dabei sind die Heizelemente vorzugsweise auf Vorsprüngen der Heizplatte angeordnet. Die Form und Anzahl der Heizelemente ist an die Form der zu behandelnden Substrate angepaßt, so daß sie sich vorteilhafterweise entlang der Außenkonturen der zu behandelnden Substrate erstrecken. Für eine Vereinfachung der Steuerung besitzen vorzugsweise alle Heizelemente die gleiche Form und Größe.

Für eine optimale Einstellung der an der Erwärmung der problematischen Randbereiche beteiligten Heizelemente ist die Lage des Substrats bezüglich der Heizplatte vorzugsweise veränderbar.

Bei einer bevorzugten Ausführungsform der Erfindung ist ein PID-Regler pro Heizelement vorgesehen. Vorzugsweise sind die Rechnereinheit, die Prozeßsteuereinheit und/oder die PID-Regler in einer Einheit zusammengefaßt.

Bei einer weiteren bevorzugten Ausführungsform der Erfindung weist die Temperatur-Meßvorrichtung eine Abtastvorrichtung zum sequentiellen Abtasten der von der Heizplatte abgewandten Seite des Substrats auf, um auf einfache Weise eine ortsaufgelöste Messung der Temperatur der Substratoberfläche zu erhalten. Dabei weist die Abtastvorrichtung vorzugsweise einen bewegbaren Spiegel auf, um ohne die Notwendigkeit, die gesamte Vorrichtung hin und her zu bewegen, das Sichtfeld der Temperatur-Meßvorrichtung über die Substratoberfläche hinwegzubewegen. Vorzugsweise ist die Temperatur-Meßvorrichtung eine Infrarot (IR)-Kamera.

In einer bevorzugten Anwendungsform der Vorrichtung ist das Substrat eine Photomaske.

Die der Erfindung zugrunde liegende Aufgabe wird bei einem Verfahren zum thermischen Behandeln von Substraten, bei dem das Substrat mit einer Heizplatte beheizt und die Temperatur der von der Heizplatte abgewandten Oberfläche des Substrats ortsaufgelöst gemessen wird, durch die folgenden Verfahrensschritte gelöst: Aufheizen der Heizplatte über eine Vielzahl von separat ansteuerbaren Heizelementen, Messen der Temperatur der Heizelemente, Regeln des Aufheizvorgangs mit einem PID-Regler, Ermitteln der Temperaturverteilung auf der Substratoberfläche in Abhängigkeit von den gemessenen Temperaturen, Ermitteln von Temperatur-Sollwerten für die einzelnen Heizelemente, und Weiterleiten der Temperatur-Sollwerte an den PID-Regler.Bei diesem Verfahren ergeben sich die schon oben genannten Vorteile einer homogenen thermischen Behandlung des Substrats durch aktive Rückkopplung. Dabei werden die einzelnen Heizelemente vorzugsweise über einzeln zugeordnete PID-Regler geregelt.

Bei einer bevorzugten Ausführungsform der Erfindung wird die von der Heizplatte abgewandte Seite des Substrats bei der Temperaturmessung sequentiell abgetastet, um auf einfache Weise eine ortsaufgelöste TemperaturMessung zu ermöglichen. Dabei wird die Abtastung vorzugsweise durch Bewegen eines Spiegels erreicht.

Bei einer besonders bevorzugten Ausführungsform der Erfindung wird die Temperatur der von der Heizplatte abgewandten Seite des Substrats mit einer IR-Kamera gemessen. Vorzugsweise wird das erfindungsgemäße Verfahren bei Photomasken eingesetzt.

Die Erfindung wird nachfolgend anhand eines bevorzugten Ausführungsbeispiels unter Bezugnahme auf die Zeichnungen erläutert; in den Zeichnungen zeigt:
- Fig. 1a: eine Ansicht von unten auf eine Heizplatte gemäß der Erfindung und
- Fig. 1b: eine Seitenansicht der Heizplatte;
- Fig. 2: eine Ansicht von oben auf die Heizplatte gemäß Fig. 1 mit darüber angeordnetem Substrat;
- Fig. 3: eine schematische Darstellung der erfindungsgemäßen Vorrichtung zum thermischen Behandeln von Substraten;
- Fig. 4: eine schematische Darstellung eines alternativen Ausführungsbeispiels der erfindungsgemäßen Vorrichtung zum thermischen Behandeln von Substraten;
- Fig. 5: eine graphische Darstellung der Heizplatte mit eingetragenen Ist-und Soll-Temperaturen unterschiedlicher Zonen der Heizplatte.

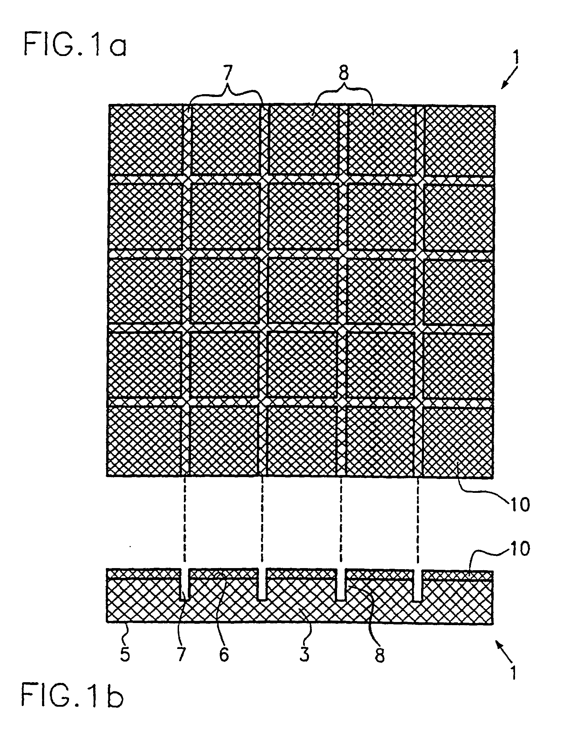

In den Fig. 1a und 1b sind eine Ansicht von unten sowie eine Seitenansicht einer zonengesteuerten Heizplatte 1 der vorliegenden Erfindung gezeigt.

Die Heizplatte 1 besteht aus einer quadratischen Grundplatte 3 mit einem im wesentlichen rechteckigen Querschnitt. Die Grundplatte 3 besitzt eine erste ebene Oberseite 5 und eine zweite, segmentierte Oberseite 6. Die Oberseite 6 wird durch jeweils vier sich senkrecht zu den Seitenkanten der Heizplatte erstreckende Nuten 7 in insgesamt 25 quadratische Segmente 8 aufgeteilt. Die Tiefe der Nuten 7 entspricht ungefähr der halben Dicke der Grundplatte 3. Auf den quadratischen Segmenten 8 der Heizplatte 3 sind jeweils quadratische Heizelemente 10 angeordnet, die in geeigneter Weise, wie z. B. durch Verkleben mit den Segmenten 8 der Grundplatte 3 verbunden sind und den Segmenten 8 entsprechende Heizzonen bilden. Durch die Anordnung der Heizelemente 10 auf den jeweiligen durch die Nuten 7 getrennten Segmenten 8 sind sie thermisch voneinander getrennt, so daß sie sich nicht gegenseitig beeinflussen, d. h. daß kein thermisches Übersprechen zwischen den Heizelementen auftritt. Über die Grundplatte 3 sind die Heizelemente 10 jedoch ausreichend thermisch miteinander gekoppelt, daß auf der Oberseite 5 der Grundplatte 3 eine homogene Temperaturverteilung ohne eine thermische Ausprägung der einzelnen Heizelemente im thermischen Bild der Oberseite 5 erreicht wird. Jedem Heizelement 10 ist ein nicht gezeigter Temperatursensor in der Form eines Thermoelements zugeordnet, der die IST-Temperatur der Heizelemente 10 mißt. Anstelle der Thermoelemente ist auch die Verwendung anderer, z.B. optischer Temperatursensoren möglich.

Obwohl die Heizplatte 1 als eine einteilige Grundplatte 3 mit darin ausgebildeten Nuten 7 zur Segmentierung der Oberseite 6 der Grundplatte 3 beschrieben wurde, sei bemerkt, daß die Grundplatte 3 vollständig eben ausgebildet sein kann und die Heizelemente 10 direkt oder über Abstandselemente mit der Grundplatte 3 verbunden sind. In gleicher Weise ist die Erfindung nicht auf die Form und Anzahl der Segmente 8 und der Heizelemente 10 beschränkt.

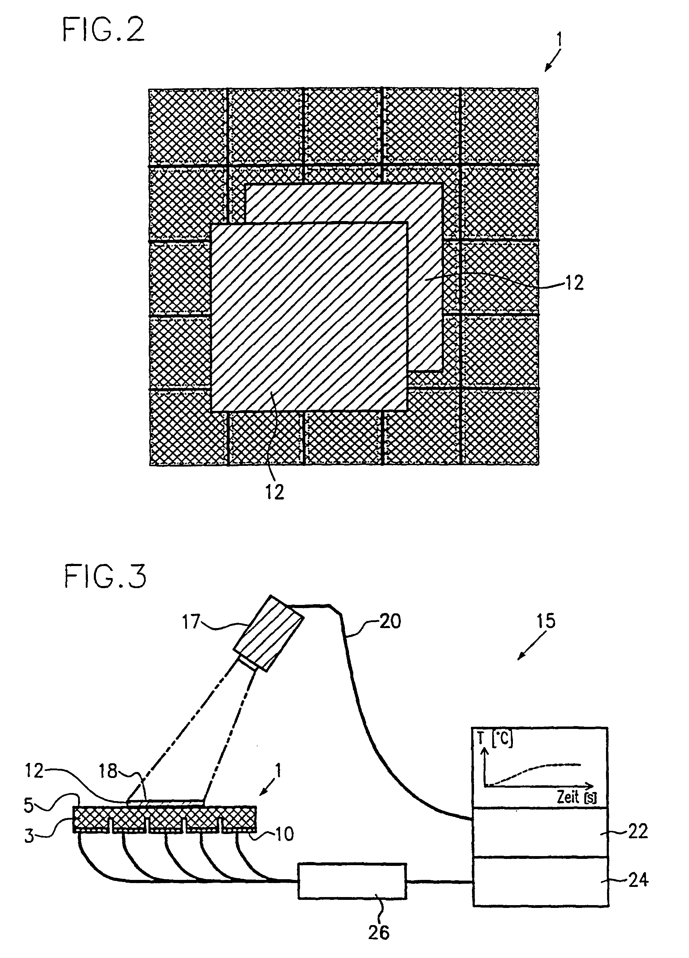

Fig. 2 zeigt eine schematische Draufsicht auf die Heizplatte 1, wobei die in der Draufsicht nicht erkennbaren Nuten 7 und Heizelemente 10 schematisch angedeutet sind. Oberhalb der Heizplatte 1 ist ein Substrat 12 in zwei unterschiedlichen Positionen bezüglich der Heizplatte dargestellt. Bei der ersten, zentrierten Position des Substrats 12 überdeckt es die mittleren neun der insgesamt 25 Heizzonen der Heizplatte 1. Daher sind bei einer thermischen Behandlung des Substrats im wesentlichen nur diese neun Zonen beteiligt und von Interesse. Bei der zweiten Position des Substrats 12 überdeckt dieses, zumindest in Teilbereichen, insgesamt 16 Heizzonen der Heizplatte 1, so daß bei einer thermischen Behandlung des Substrats 12 diese 16 Heizzonen beteiligt und von Interesse wären. Durch die Darstellung dieser zwei Positionen wird deutlich, daß durch die Positionswahl des Substrats die Anzahl der bei der thermischen Behandlung beteiligten Heizelemente variiert und auf ein Optimum angepaßt werden kann.

Fig. 3 zeigt eine schematische Darstellung einer Vorrichtung 15 zum thermischen Behandeln des Substrats 12. Die thermische Behandlungsvorrichtung 15 umfaßt die in den Fig. 1 und 2 dargestellte Heizplatte 1 zum thermischen Behandeln des Substrats 12. Die ebene Oberseite 5 der Grundplatte 3 der Heizplatte 1 ist benachbart zu einem zu behandelnden Substrat 12, z. B. mit einem Abstand zwischen 0,1 und 0,5 mm, angeordnet. Das Substrat wird beispielsweise auf vier nicht dargestellten Halterungen über der Heizplatte 1 gehalten. Oberhalb der Heizplatte 1 und des Substrats 12 ist eine Temperatur-Meßvorrichtung 17 in der Form einer Infrarot-Kamera angeordnet. Die Infrarot-Kamera 17 ist auf eine von der Heizplatte 1 abgewandte Oberseite 18 des Substrats 12 gerichtet. Die Infrarot-Kamera 17 beinhaltet eine nicht näher dargestellte Scan-Vorrichtung mit einem bewegbaren Spiegel, über den sequentiell die gesamte Oberfläche 18 des Substrats 12 abgetastet wird. Über die Scan-Vorrichtung wird ein ortsaufgelöstes Bild der Temperaturverteilung der Oberseite 18 des Substrats 12 erzeugt, wobei die gesamte Oberfläche beispielsweise einmal pro Sekunde abgetastet wird.

Die Infrarot-Kamera 17 ist über eine Datenleitung 20 mit einer Rechnereinheit in der Form eines PC's 22 verbunden. Innerhalb des PC's werden die von der IR-Kamera erhaltenen Meßwerte verarbeitet und eine räumliche Temperaturverteilung auf der Oberfläche 18 des Substrats 12 ermittelt. Anhand dieser Temperaturverteilungsdaten, die an eine Prozeßsteuerung 24 weitergeleitet werden, ermittelt diese Temperatur-Sollwerte für die Heizelemente 10.

Diese Temperatur-Sollwerte werden an einen PID-Regler 26 weitergeleitet, der mit den einzelnen Heizelementen 10 und den Temperatursensoren verbunden ist und mit diesen einen Regelkreis bildet. Der PID-Regler regelt die Heizleistung der einzelnen Heizelemente 10 anhand der durch die Prozeßsteuerung vorgegebenen Temperatur-Sollwerte und der durch die Temperatursensoren gemessenen Temperatur-Istwerte. Somit wird auf den Regelkreis bestehend aus PID-Regler 26, Heizelementen 10 und Temperatursensoren in bestimmter geregelter Weise durch Vorgabe der Temperatur-Sollwerte die Abhängigkeit der Temperaturverteilung auf der Substratoberfläche ermittelt werden. Insofern besteht zu dem Regelkreis aus PID-Regler 26, Heizelementen 10 und Temperatursensor ein übergeordneter Regelkreis.

Diese aktive Regelung wird während der gesamten thermischen Behandlung des Substrats 12, insbesondere auch in der Aufheizphase durchgeführt, wobei die einzelnen Heizelemente jeweils derart geregelt werden, daß auf der Oberseite 18 des Substrats 12 eine homogene gleichförmige Temperaturverteilung erreicht wird. Die einzelnen Heizelemente werden beispielsweise in einem Temperaturbereich von 20°C bis 400°C stufenlos geregelt.

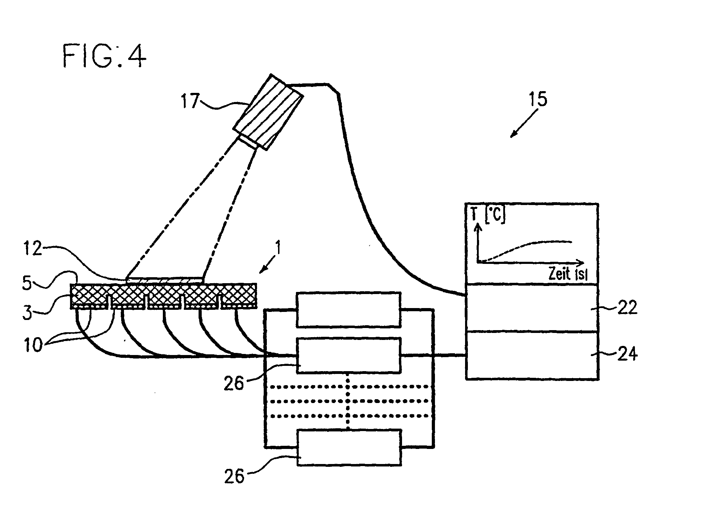

Fig. 4 zeigt eine alternative Ausführungsform der Vorrichtung 15, wobei der einzige Unterschied zwischen dem Ausführungsbeispiel gemäß Fig. 3 darin besteht, daß jedem Heizelement 10 ein eigener PID-Regler 26 zugeordnet ist.

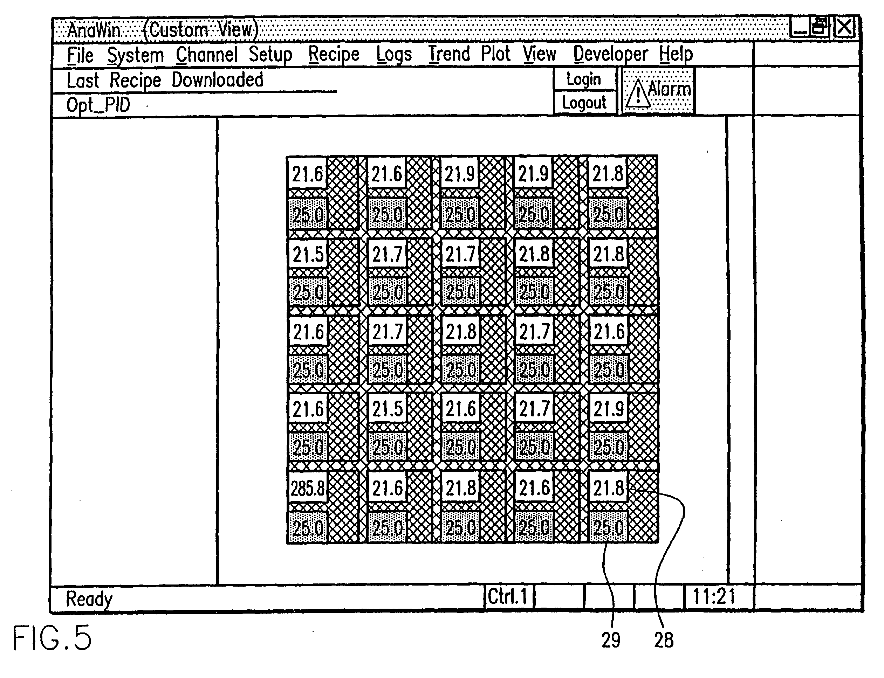

Fig. 5 zeigt eine graphische Darstellung der Heizplatte 1, wobei die jeweils gemessenen Ist-Temperaturen der Heizelemente innerhalb eines ersten hellen Kästchens 28 angegeben sind. Die jeweils in Abhängigkeit von der Temperaturverteilung auf der Oberseite 18 des Substrats 12 von der Prozeßsteuerung vorgegebenen Soll-Werte sind für die einzelnen Heizelemente in Kästchen 29 angegeben.

Die Erfindung wurde zuvor anhand eines bevorzugten Ausführungsbeispiels der Erfindung beschrieben, ohne jedoch auf die spezielle Ausführungsform beschränkt zu sein. Beispielsweise könnte die Heizplatte eine andere, wie z. B. eine runde Form, mit runden oder Kreissegmenten bildenden Heizelémenten aufweisen. Statt einer Infrarot-Kamera könnte auch eine andere, ortsauflösende Temperatur-Meßvorrichtung verwendet werden. Darüber hinaus ist es auch möglich, die Rechnereinheit, die Prozeßsteuerung und die PID-Regler innerhalb einer einzelnen Einheit auszubilden.

## Patentansprüche

1. Vorrichtung (15) zum thermischen Behandeln von Substraten (12) mit einer Heizplatte (1), die eine Vielzahl von separat ansteuerbaren Heizelementen (10) auf einer vom Substrat (12) abgewandten Seite (6) der Heizplatte (1) aufweist, und einer auf die von der Heizplatte (1) abgewandte Oberfläche (18) des Substrats (12) gerichtete, ortsauflösende Temperatur-Meßvorrichtung (17), **gekennzeichnet durch**
- wenigstens einen Temperatursensor zum Abfühlen der Temperatur der Heizelemente (10),
- wenigstens einen mit den Heizelementen (10) und dem wenigstens einen Temperatursensor in Verbindung stehenden PID-Regler (26),
- eine mit der Temperatur-Meßvorrichtung (17) in Verbindung stehende Rechnereinheit (22), die die Temperaturverteilung auf der Substratoberfläche ermittelt, und
- eine mit der Rechnereinheit (22) in Verbindung stehende Prozeßsteuereinheit (24), die in Abhängigkeit von der Temperaturverteilung auf der Substratoberfläche (18) Temperatur-Sollwerte für die einzelnen Heizelemente (10) ermittelt und an den PID-Regler weiterleitet

2. Vorrichtung (15) nach Anspruch 1, **dadurch gekennzeichnet, daß** die Heizelemente (10) auf der vom Substrat (12) abgewandten Seite (6) der Heizplatte (1) voneinander beabstandet sind.

3. Vorrichtung (15) nach Anspruch 1 oder 2, **dadurch gekennzeichnet, daß** die Heizelemente (10) auf Vorsprüngen (8) der Heizplatte (1) angeordnet sind.

4. Vorrichtung (15) nach einem der vorhergehenden Ansprüche, **dadurch gekennzeichnet, daß** die Form und Anzahl der Heizelemente (10) an die Form der zu behandelnden Substrate (12) angepaßt ist.

5. Vorrichtung (15) nach einem der vorhergehenden Ansprüche, **dadurch gekennzeichnet, daß** die Heizelemente (10) jeweils die gleiche Form und Größe besitzen.

6. Vorrichtung (15) nach einem der vorhergehenden Ansprüche, **dadurch gekennzeichnet, daß** die Lage des Substrats (12) bezüglich der Heizplatte (1) veränderbar ist.

7. Vorrichtung (15) nach einem der vorhergehenden Ansprüche, **gekennzeichnet durch** einen PID-Regler (26) pro Heizelement (10).

8. Vorrichtung (15) nach einem der vorhergehenden Ansprüche, **dadurch gekennzeichnet, daß** die Rechnereinheit (22), die Prozeßsteuereinheit (24) und/oder die PID-Regler (26) in einer Einheit zusammengefaßt sind.

9. Vorrichtung (15) nach einem der vorhergehenden Ansprüche, **dadurch gekennzeichnet, daß** die Temperatur-Meßvorrichtung (17) eine Abtastvorrichtung zum sequentiellen Abtasten der von der Heizplatte (1) abgewandten Seite des Substrats (12) aufweist.

10. Vorrichtung (15) nach Anspruch 9, **dadurch gekennzeichnet, daß** die Abtastvorrichtung einen bewegbaren Spiegel aufweist.

11. Vorrichtung (15) nach einem der vorhergehenden Ansprüche, **dadurch gekennzeichnet, daß** die Temperatur-Meßvorrichtung (17) eine IR-Kamera ist.

12. Vorrichtung (15) nach einem der vorhergehenden Ansprüche, **dadurch gekennzeichnet, daß** das Substrat (12) eine Photomaske ist.

13. Verfahren zum thermischen Behandeln von Substraten (12), bei dem das Substrat mit einer Heizplatte (1) über eine Vielzahl von separat ansteuerbaren Heizelementen (10) beheizt und die Temperatur der von der Heizplatte (1) abgewandten Oberfläche (18) des Substrats (12) ortsaufgelöst gemessen wird, wobei das Verfahren die folgenden Verfahrensschritte aufweist:
- Messen der Ist-Temperatur der Heizelemente (10),
- Regeln des Aufheizvorgangs mit einem PID-Regler (26),
- Ermitteln der Temperaturverteilung auf der Substratoberfläche in Abhängigkeit von den gemessenen Temperaturen;
- Ermitteln von Temperatur-Sollwerten für die einzelnen Heizelemente (10) in Abhängigkeit von der Temperaturverteilung auf der Substratoberfläche, und
- Übermitteln der Temperatur-Sollwerte an den PID-Regler.

14. Verfahren nach Anspruch 13, **dadurch gekennzeichnet, daß** die einzelnen Heizelemente (10) über einzeln zugeordnete PID-Regler (26) geregelt werden.

15. Verfahren nach einem der Ansprüche 13 oder 14, **dadurch gekennzeichnet, daß** die von der Heizplatte (1) abgewandten Oberfläche (18) des Substrats (12) bei der Temperaturmessung sequentiell abgetastet wird.

16. Verfahren nach Anspruch 15, **dadurch gekennzeichnet, dass** das Abtasten durch Bewegen eines Spiegels erfolgt.

17. Verfahren nach einem der Ansprüche 13 bis 16, **dadurch gekennzeichnet, daß** die Temperatur der von der Heizplatte (1) abgewandten Oberfläche (18) des Substrats (12) mit einer IR-Kamera (17) gemessen wird.

18. Verfahren nach einem der Ansprüche 13 bis 17, **dadurch gekennzeichnet, daß** das Substrat (12) eine Photomaske ist.

## Claims

1. Device (15) for the thermal treatment of substrates (12), with a heating plate (1), which comprises a plurality of separately controllable heating elements (10) on a side (6) of the heating plate (1) facing away from the substrate (12), and a locally resolving temperature measuring device (17) oriented towards the surface (18) of the substrate (12) remote from the heating bracket (1), **characterised by**
- at least one temperature sensor for detecting the temperature of the heating elements (10),
- at least one PID regulator (26) disposed in connection with the heating elements (10) and the at least one temperature sensor,
- a computer unit (22), which is disposed in connection with the temperature measuring device (17) and which detects the temperature distribution on the substrate surface, and
- a process control unit (24), which is disposed in connection with the computer unit (22) and which, in dependence on the temperature distribution on the substrate surface (18), ascertains temperature target values for the individual heating elements (10) and passes them on to the PID regulator.

2. Device (15) according to claim 1, **characterised in that** the heating elements (10) on the side (6) of the heating plate (1) remote from the substrate (12) are spaced from one another.

3. Device (15) according to claim 1 or 2, **characterised in that** the heating elements (10) are arranged on protrusions (8) of the heating plate (1).

4. Device (15) according to one of the preceding claims, **characterised in that** the shape and number of the heating elements (10) are matched to the shape of the substrates (12).

5. Device (15) according to one of the preceding claims, **characterised in that** the heating elements (10) each have the same shape and size.

6. Device (15) according to one of the preceding claims, **characterised in that** the position of the substrate (12) with respect to the heating plate (1) is variable.

7. Device (15) according to one of the preceding claims, **characterised by** one PID regulator (26) per heating element (10).

8. Device (15) according to one of the preceding claims, **characterised in that** the computer unit (22), the process control unit (24) and/or the PID regulator (26) are combined into a unit.

9. Device (15) according to one of the preceding claims, **characterised in that** the temperature measuring device (17) comprises a scanning device for sequential scanning of the side of the substrate (12) remote from the heating plate (1).

10. Device (15) according to claim 9, **characterised in that** the scanning device comprises a movable mirror.

11. Device (15) according to one of the preceding claims, **characterised in that** the temperature measuring device (17) is an IR camera.

12. Device (15) according to one of the preceding claims, **characterised in that** the substrate (12) is a photo-mask.

13. Method for thermal treatment of substrates (12), in which the substrate is heated by a heating plate (1) by way of a plurality of separately controllable heating elements (10) and the temperature of the surface (18) of the substrate (12) remote from the heating plate (1) is measured in locally resolved manner, wherein the method comprises the following method steps:
- measurement of the actual temperature of the heating elements (10),
- regulation of the heating process by a PID regulator (26),
- determination of the temperature distribution on the substrate surface in dependence on the measured temperatures,
- determination of temperature target values for the individual heating elements (10) in dependence on the temperature distribution on the substrate surface, and
- communication of the temperature target values to the PID regulator.

14. Method according to claim 13, **characterised in that** the individual heating elements (10) are regulated by way of individually associated PID regulators (26).

15. Method according to one of claims 13 and 14, **characterised in that** the surface (18) of the substrate (12) remote from the heating plate (1) is sequentially scanned during the temperature measurement.

16. Method according to claim 15, **characterised in that** the scanning is carried out by movement of a mirror.

17. Method according to one of claims 13 to 16, **characterised in that** the temperature of the surface (18) of the substrate (12) remote from the heating plate (1) is measured by an IR camera (17).

18. Method according to one of claims 13 to 17, **characterised in that** the substrate (12) is a photo-mask.

## Revendications

1. Dispositif (15) pour le traitement thermique de substrats (12) avec une plaque chauffante (11) qui présente une pluralité d'éléments chauffants (10) pouvant être commandés séparément sur un côté (6) de la plaque chauffante (1) éloigné du substrat (12), et un dispositif de mesure de température (17) à définition locale, orienté vers la surface (18) du substrat (12) éloignée de la plaque chauffante (1), **caractérisé par**
- au moins un capteur de température pour détecter la température des éléments chauffants (10),
- au moins un régulateur PID (26) en liaison avec les éléments chauffants (10) et au moins un capteur de température,
- une unité de calcul (22) en liaison avec le dispositif de mesure de température (17), qui détermine la distribution de la température sur la surface du substrat et
- une unité de commande de processus (24) en liaison avec l'unité de calcul (22) qui détermine en fonction de la distribution de la température sur la surface du substrat (18) des valeurs de consigne de température pour les éléments chauffants individuels (10) et les transmet au régulateur PID.

2. Dispositif (15) selon la revendication 1, **caractérisé en ce que** les éléments chauffants (10) sont espacés les uns des autres sur le côté (6) de la plaque chauffante (1), éloigné du substrat (12).

3. Dispositif (15) selon la revendication 1 ou 2, **caractérisé en ce que** les éléments chauffants (10) sont disposés sur des saillies (8) de la plaque chauffante (1).

4. Dispositif (15) selon l'une des revendications précédentes, **caractérisé en ce que** la forme et le nombre des éléments chauffants (10) sont adaptés à la forme des substrats à traiter (12).

5. Dispositif (15) selon l'une des revendications précédentes, **caractérisé en ce que** les éléments chauffants (10) ont respectivement la même forme et grandeur.

6. Dispositif (15) selon l'une des revendications précédentes, **caractérisé en ce que** la position du substrat (12) par rapport à la plaque chauffante (1) peut être modifiée.

7. Dispositif (15) selon l'une des revendications précédentes, **caractérisé par** un régulateur PID (26) par élément chauffant (10).

8. Dispositif (15) selon l'une des revendications précédentes, **caractérisé en ce que** l'unité de calcul (22), l'unité de commande de processus (24) et/ou les régulateurs PID (26) sont réunis pour former une unité.

9. Dispositif (15) selon l'une des revendications précédentes, **caractérisé en ce que** le dispositif de mesure de température (17) présente un dispositif d'exploration pour explorer séquentiellement le côté du substrat éloigné de la plaque chauffante (1).

10. Dispositif (15) selon la revendication 9, **caractérisé en ce que** le dispositif d'exploration présente un miroir mobile.

11. Dispositif (15) selon l'une des revendications précédentes, **caractérisé en ce que** le dispositif de mesure de température (17) est une caméra IR.

12. Dispositif (15) selon l'une des revendications précédentes, **caractérisé en ce que** le substrat (12) est un photomasque.

13. Procédé pour le traitement thermique de substrats (12), où le substrat est chauffé avec une plaque chauffante (1) par une pluralité d'éléments chauffants (10) pouvant être commandés séparément, et la température de la surface (18) du substrat (12) éloignée de la plaque chauffante (1) est mesurée avec une définition locale, où le procédé présente les étapes de procédé suivantes :
- la mesure de la température réelle des éléments chauffants (10),
- le réglage de l'opération de chauffage avec un régulateur PID (26),
- la détermination de la répartition de la température sur la surface du substrat en fonction des températures mesurées ;
- la détermination de valeurs de consigne de température pour les éléments chauffants individuels (10) en fonction de la répartition de la température sur la surface du substrat, et
- la transmission des valeurs de consigne de température au régulateur PID.

14. Procédé selon la revendication 13, **caractérisé en ce que** les éléments chauffants individuels (10) sont réglés par des régulateurs PID (26) associés individuellement.

15. Procédé selon l'une des revendications 13 ou 14, **caractérisé en ce que** la surface (18) du substrat (12) éloignée de la plaque chauffante (1) est balayée séquentiellement lors de la mesure de la température.

16. Procédé selon la revendication 15, **caractérisé en ce que** le balayage a lieu par le déplacement d'un miroir.

17. Procédé selon l'une les revendications 13 à 16, **caractérisé en ce que** la température de la surface (18) du substrat (12) éloignée de la plaque chauffante (1) est mesurée avec une caméra IR (17).

18. Procédé selon l'une des revendications 13 à 17, **caractérisé en ce que** le substrat (12) est un photomasque.
